Europäisches Patentamt

European Patent Office

Office européen des brevets

(11) Publication number: **0 415 610 A2**

# EUROPEAN PATENT APPLICATION

(21) Application number: 90309054.6

(51) Int. Cl.⁵: **H04B 1/16**

(22) Date of filing: 17.08.90

(30) Priority: 28.08.89 US 399948

(43) Date of publication of application:
06.03.91 Bulletin 91/10

(84) Designated Contracting States:
DE FR GB IT

(71) Applicant: DELCO ELECTRONICS
CORPORATION
700 East Firmin Street
Kokomo Indiana 46902(US)

(72) Inventor: Zarabadi, Seyed R.
3022 St. John Court No. 2
Columbus, Ohio 43202(US)
Inventor: Kennedy, Richard A.
R.R. No. 3 Box 33
Russiaville, Indiana 46979(US)
Inventor: Padgett, Myron G.
10322 East 170 Street
Greentown, Indiana 46936(US)

(74) Representative: Denton, Michael John et al
Patent Section Vauxhall Motors Limited 1st
Floor Gideon House 26 Chapel Street
Luton Bedfordshire LU1 2SE(GB)

(54) **Radio receiver.**

(57) A Stop On Station (SOS) circuit (120) of an AM/FM radio receiver (100) comprises means (118,207) for measuring the amplitude and frequency of a candidate radio signal. The frequency measuring means (207) comprises a counter (207) and a decode circuit (209,210) to detect the deviation in frequency of the received signal with a centre reference frequency. A persistence counter (229) determines the stability of the frequency over a plurality of samples and outputs a frequency output signal if this is within acceptable limits. The signal strength measuring means (118) compares the strength of the signal with a reference value and outputs a strength output signal if the measured strength is greater than the reference value. Generation of both the frequency and strength output signals causes the candidate radio signal to be selected for listening to.

A noise measuring circuit (117) is used when FM signals are being tested and outputs a noise output signal if noise is within acceptable limits. Generation of all three output signals, noise, frequency and strength, causes the FM candidate signal to be selected for listening to.

If one of the criteria is not met for the candidate radio signal, an alternative candidate signal is selected for testing.

EP 0 415 610 A2

# FIG. 1

## RADIO RECEIVER

This invention relates to improvements in or relating to radio receivers and in particular to means for testing received signals. The invention is adapted for use with a "Stop on Station" facility of an AM/FM radio receiver.

Many modern radio receivers provide "seek" and "scan" facilities which are respectively initiated by depression of seek and scan buttons. In response to a request for either of these facilities, the radio receiver searches for the next station signal that meets certain criteria. In the case of a "seek" request, the receiver terminates the search when a suitable station signal is found; and in the case of "scan" request, the receiver temporarily locks onto a station signal that meets the criteria to permit a listener to preview the current program. The listener can terminate the scan by again depressing the scan button. If the listener does not terminate the scan, the receiver searches and locks onto candidate station signals for short preview periods of time and terminates the scan when the end of the frequency band is reached.

Prior art "Stop on Station" (SOS) circuits use received signal field strength to determine if a received radio (station) signal is acceptable for listening to or not. Such prior art SOS circuits are generally termed "AGC" for Automatic Gain Control. However, since received signal strength may vary substantially within short periods of time, such prior art SOS circuits may stop on radio station signals which are inadequate for good listening or may pass over signals which are in fact acceptable for listening. Variation in received signal strength is typically more noticeable in automobile radios than in home receivers.

The invention is characterised over the prior art by those features defined in the characterising portion of claim 1.

According to another aspect of the present invention, there is provided apparatus for testing the suitability of a radio signal for listening purposes, which radio signal has been transferred onto an Intermediate Frequency, the apparatus comprising means to measure the frequency of the transferred signal, means to measure the deviation in frequency of the signal from the Intermediate Frequency, and means to compare the deviation with a predetermined value, the result of the comparison being indicative of the suitability of the signal.

An embodiment of the present invention is directed to a Stop On Station (SOS) circuit for use with a radio receiver. The SOS circuit evaluates the field strength of a received signal together with one or more additional parameters of the signal in order to identify signals of candidate stations which are suitable for listening to. In the case of AM and FM radio signals, the received signal is mixed with the signal from a local AM or FM tuned oscillator to produce an Intermediate Frequency (IF) signal (e.g., the second IF signal in the receiver) the frequency of which is measured and evaluated so as to assure that the mixed received signal is substantially centred at the second IF frequency.

In the embodiment described below, the IF frequency for a received candidate radio signal is evaluated for a period of time, typically 40 milliseconds. During each 40 millisecond (ms) period, 15 samples of the of the IF signal are taken and their frequency counted and evaluated. If the frequency of the measured signal falls within acceptable limits, a four stage binary persistence counter of the SOS circuit is incremented. If a count of 12 or more out of the 15 possible counts is accumulated in the counter during the 40 ms evaluation period, the received radio signal is considered to be acceptable from a standpoint of received frequency and a "frequency pass" signal is generated by the SOS circuit. The receiver also generates an Automatic Gain Control (AGC) signal which is coupled to an input of the SOS circuit. The SOS circuit generates a lock on (stop, hold) signal if the AGC signal is above a predetermined threshold at the time the frequency pass signal occurs. In such an event, the radio receiver locks onto the candidate radio signal which has just been tested and found acceptable for listening to. On the other hand, if the AGC signal is below the preselected threshold at the time the frequency pass signal occurs, the SOS Circuit rejects that candidate radio signal and causes the radio receiver to select and test another candidate radio signal.

In the case of FM signals, the magnitude of ultrasonic noise (noise in the range of 100 kHz to 200 kHz) in the output of an FM detector of the receiver is measured and serves as another input to the SOS circuit. Noise above a threshold value results in the SOS circuit generating a non-select signal which rejects a particular candidate radio signal just tested even if the results of the frequency test and the AGC signal are acceptable.

An embodiment of the invention is described below, by way of example only, with reference to the accompanying drawings, in which:

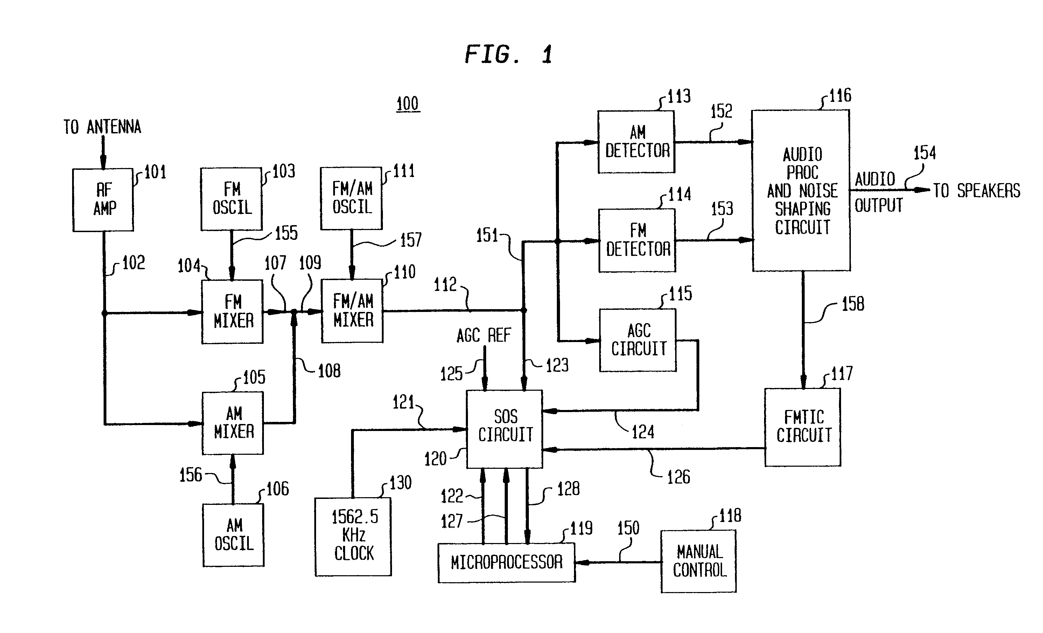

Figure 1 is a block diagram of an AM/FM radio receiver incorporating a Stop on Station (SOS) circuit in accordance with and embodiment of the present invention;

Fiqure 2 is a schematic and block diagram of the SOS circuit of Figure 1; and

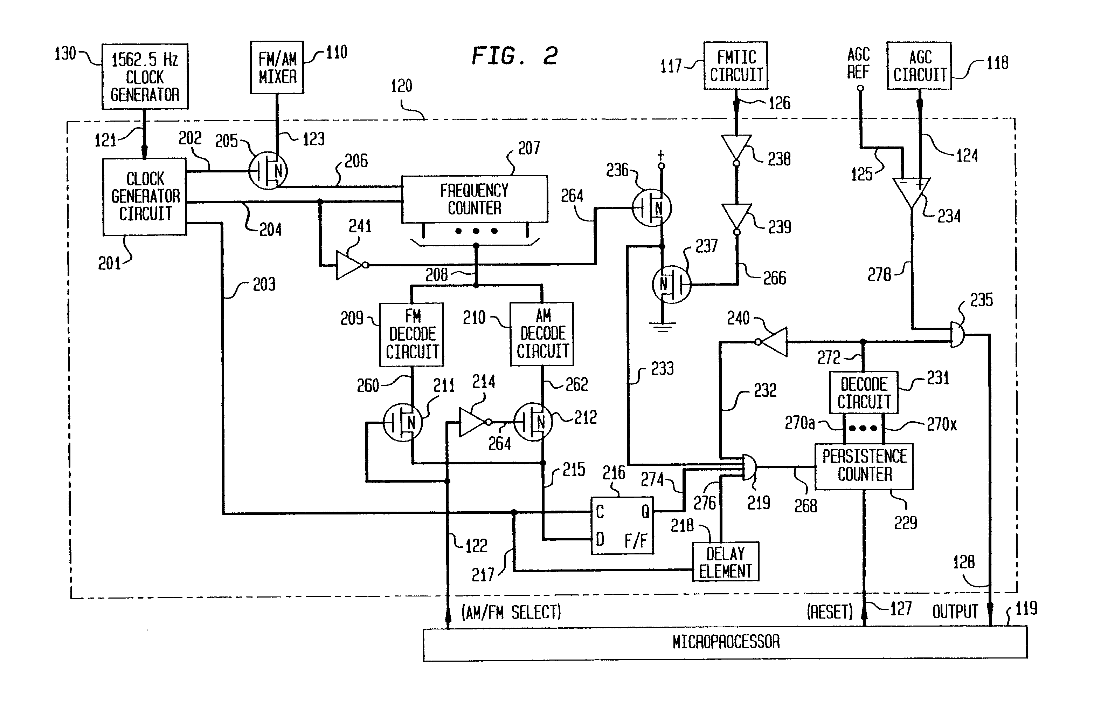

Fiqure 3 illustrates several timing signals used with and/or generated by the SOS circuit of Figure 2.

Referring to Figure 1, there is shown an AM/FM radio receiver 100. Receiver 100 comprises a Stop On Station (SOS) circuit 120 and in addition comprises a radio frequency amplifier (shown as RF Amp) 101, a frequency modulation oscillator (shown as FM Oscil) 103, a frequency modulation mixer (shown as FM Mixer) 104, an amplitude modulation mixer (shown as AM Mixer) 105, an amplitude modulation oscillator (shown as AM Oscil) 106, a frequency modulation/amplitude modulation oscillator (shown as FM/AM Oscil) 111, a frequency modulation/amplitude modulation mixer (shown as FM/AM Mixer) 110, a fixed frequency generator (shown as 1562.5 Hz Clock) 130, a microprocessor 119, a manual control 118, an amplitude modulation detector (shown as AM Detector) 113, a frequency modulation detector (shown as FM Detector) 114, an automatic gain control circuit (shown as AGC Circuit) 115, an audio processor and signal shaping circuit (shown as Audio Proc) 116 and an ultra-sonic noise signal generating circuit (shown as FMTIC Circuit) 117. The FMTIC circuit 117 provides an output representative of impulse and automobile ignition noise. SOS circuit 120 is adapted to perform rapidly multiple tests on an intermediate frequency (IF) of a radio frequency (RF) received by an antenna (not shown) coupled to the RF amplifier 101, to accept the incoming RF signal and to select or reject that radio signal.

Only principal signal paths and functional blocks of the AM/FM radio receiver 100 are shown. Features such as filters and control signal paths are not shown. Manual control 118 comprises controls for selecting AM or FM radio stations, initiating seek and scan operations, determining tone characteristics, controlling volume etc.

RF signals generated by radio stations are received on an antenna (not shown) coupled to the RF amplifier 101 by which they are amplified. These amplified radio signals are coupled via a conductor 102 to the FM mixer 104 and to the AM mixer 105. The output of the FM oscillator 103 is coupled to an input of the FM mixer 104 via a conductor 155. The output of the AM oscillator 106 is coupled to an input of the AM mixer 105 via a conductor 156. The outputs of the FM mixer 104 and the AM mixer 105 are coupled via conductors 107 and 108, respectively, to a conductor 109 which is coupled to an input of the FM/AM mixer 110. A manual selector (not shown) coupled to the FM mixer 104 and to the AM mixer 105 determines which of the FM mixer 104 and the AM mixer 105 is selected and activated.

The output of the FM/AM mixer 110 is coupled via a conductor 112 to a conductor 123 which is coupled to a first input of the SOS circuit 120 and to a conductor 151 which is coupled to the respective inputs of the AM detector 113, the FM detector 114 and AGC circuit 115. The output of the AM detector 113 is coupled to an input of the audio processing circuit 116 via a conductor 152. The output of the FM detector 114 is coupled via a conductor 153 to an input of the audio processing circuit 116. The audio output of the audio processing circuit 116 is coupled to speakers (not shown) via a conductor 154. A noise output of the audio processing circuit 116 is coupled to an input of the FMTIC circuit 117 via a conductor 158. An output of the AGC circuit 115 is coupled via a conductor 124 to a second input of the SOS circuit 120. The output of the FMTIC circuit 117 is coupled via a conductor 126 to a third input of the SOS circuit 120.

First and second outputs of the microprocessor 119 are coupled via conductors 122 and 127, respectively, to fourth and fifth inputs of the SOS circuit 120. A 1562.5 kHz clock 130 is coupled via a conductor 121 to a sixth input of the SOS circuit 120. A reference AGC voltage (AGC Ref) is coupled to a seventh input of the SOS circuit 120 via a conductor 125. The output of the SOS circuit 120 is coupled via a conductor 128 to the microprocessor 119. An output of the manual control 118 is coupled via a conductor 150 to a first input of the microprocessor 119.

With the FM mixer 104 selected and activated, an FM radio frequency signal is mixed with the output of the FM oscillator 103 by the FM mixer 104 such that a first intermediate frequency (IF) signal, centred at a selected frequency (e.g., 10.7 MHz), is generated by the FM mixer 104, in a similar manner to superheterodyne receivers, and sent to the FM/AM mixer 110 via conductors 107 and 109. Typically, the FM oscillator 103 is tuned, under control of signals from the microprocessor 119, to a frequency 10.7 MHz above the frequency of a selected radio station, such that a first IF signal centred at 10.7 MHz is produced. The FM/AM mixer 110 generates a second IF signal centred around 450KHz, which is output onto conductor 112.

Similarly, with the AM mixer 105 selected and activated, an AM radio frequency signal is mixed with the output of the AM oscillator 106 by the AM mixer 105 and an amplitude modulated (AM) first Intermediate Frequency (IF) signal centred at a preselected frequency (e.g., 10.7 MHz) is generated and sent to the FM/AM mixer 110 via conductors 108 and 109. The FM/AM mixer 110 converts the AM modulated IF signal to a modulated 450 kHz signal and outputs it onto the conductor 112. Tuning of the AM oscillator 106 is controlled by signals from the microprocessor 119.

The second IF signal, generated by the FM/AM mixer 110, is detected by the AM detector 113 or the FM detector 114, (depending on whether the received signal is an AM or FM signal), the outputs of which are coupled to the audio processing circuit 116. The circuit 116 generates an audio output signal which is delivered to speakers (not shown).

The SOS circuit 120 generates at its output, coupled to conductor 128, a signal which indicates whether a received candidate radio frequency signal at the input of the RF amplifier 101 is acceptable for listening to or not. If the received radio frequency signal is acceptable, the microprocessor 119 controls the appropriate components of the FM/AM receiver 100 to lock onto the received signal. If the signal is not acceptable, the microprocessor 119 rejects that particular received signal and controls the appropriate components of the FM/AM receiver 100 to select another radio frequency signal which is then subsequently tested by the SOS circuit 120.

An embodiment of SOS circuit 120 is shown within the dashed line in the block and electrical schematic diagram of Figure 2. The SOS circuit 120 comprises a clock generator circuit 201, n-channel field effect transistors 205, 211, 212, 236 and 237, a ten-bit frequency counter 207, inverters 214, 238, 239, 240 and 241, an FM decode circuit 209, an AM decode circuit 210, a D-type flop-flop 216, a delay element 218, a two-input comparator 234, a four-input AND gate 219, a two-input AND gate 235, a decode circuit 231 and a four-bit persistence counter 229.

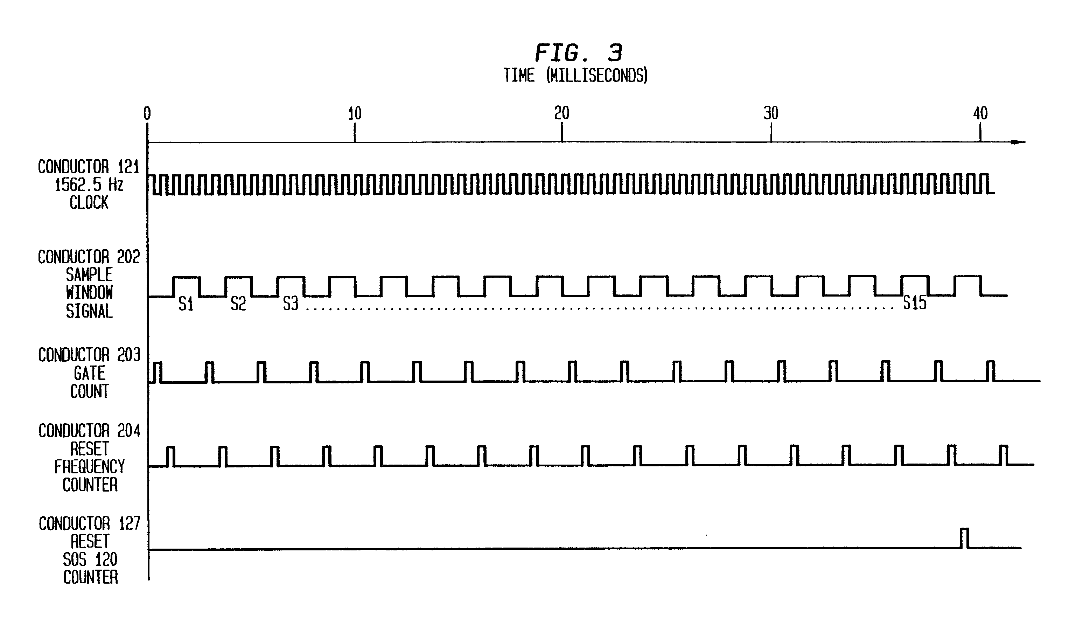

The clock circuit 201 has an input coupled to an output of the 1562.5 kHz clock generator 130 which generates a 1562.5 kHz square waveform, shown in graphical form in Figure 3 as the top waveform. The clock circuit 201 has first, second and third outputs which are coupled to conductors 202, 203, and 204 respectively. The voltage waveforms generated by the clock circuit 201 and output onto the conductors 202, 203 and 204, respectively, are shown graphically in Figure 3 as the second, third and fourth waveforms, respectively. Conductor 202 is coupled to the gate terminal of n-channel Metal-Oxide-Semiconductor (MOS) transistor 205. Conductor 203 is coupled to a clock input (C) of flip-flop 216 and to a first terminal of delay element 218. Conductor 204 is coupled to a control input of frequency counter 207 and to an input of inverter 241. The drain terminal of transistor 205 is coupled through the conductor 123 to the output of the FM/AM mixer 110. The outputs of frequency counter 207 are coupled via the conductor 208 to the FM decode circuit 209 and to the AM decode circuit 210. The output of the FM decode circuit 209 is coupled via a conductor 260 to the drain terminal of transistor 211. The output of the AM decode circuit 210 is coupled via a conductor 262 to the drain terminal of transistor 212. The source terminals of transistors 211 and 212 are coupled via a conductor 215 to the enable input D-input of flip-flop 216. An AM/FM select output of the microprocessor 119 is coupled via the conductor 122 to the gate terminal of transistor 211 and to an input of inverter 214. The output of the inverter 214 is coupled via a conductor 264 to the gate terminal of transistor 212.

Each time the voltage on conductor 202 goes to a high level, which occurs 15 times during each 40 microsecond time period, the transistor 205 is enabled (biased on) and a sample of the second IF signal from the FM/AM mixer 110 is transferred from the drain to the source of transistor 205 to be input to the frequency counter 207.

The sample period of the frequency counter 207 in this embdiment is 1.28 milliseconds. In the case of a 450 khz second IF signal, the ten-bit counter 207 reaches a count of 576 in the 1.28 millisecond sampling period. The counter 207 is reset by a high level signal, a "reset frequency counter" signal on the conductor 204. This reset signal, which is graphically shown as the fourth waveform in Figure 3, occurs once every 2.56 milliseconds. The 1.28 millisecond sampling period of counter 207 occupies the first half of the 2.56 millisecond period in between reset signals. During the second 1.28 milliseconds of each 2.56 millisecond period, one of the decode circuits 209, 210 is enabled whilst the other is disabled. An output signal from the enabled decode circuit 209, 210 is coupled through its respective transistor 211, 212 to the D-input of the flip-flop 216. If the FM decode circuit 209 is to be enabled, the AM/FM select output of microprocessor 119 is high, thereby enabling transistor 211 and disabling transistor 212. On the other hand, if the AM decode circuit 210 is to be enabled, the microprocessor 119 outputs a low level signal onto conductor 122 which enables transistor 212 and disables transistor 211.

The output of inverter 241 is coupled to the gate terminal of transistor 236 via conductor 264. The drain terminal of transistor 236 is coupled to a positive voltage source, shown by a " + " sign. The source terminal of transistor 236 is coupled to the drain terminal of transistor 237 and to a first input of the AND gate 219 via conductor 233.

The series combination of inverters 238 and 239 form a buffer circuit having an input formed by the input of the first inverter 238, which is coupled to the output of the FMTIC circuit 117, and an output formed by the output of the second inverter 239. The output of the buffer is connected to the gate terminal of the transistor 237 and, as will be apparent, supplies to the gate terminal of the transistor 237 signals equivalent to the output of the FMTIC circuit 117.

An end of cycle (reset) output of the microprocessor 119 is coupled to the reset input of the four-bit persistence counter 229 by means of the conductor 127. An information input of the persistence counter 229 is coupled to the output of AND gate 219 via a conductor 268. The outputs of the persistence counter 229 are coupled to the inputs of decode circuit 231 via conductors 270a through 270x. The output of the decode circuit 231 is coupled to the input of inverter 240 and to a first input of AND gate 235 by means of conductor 272. The output of the inverter 240 is coupled to a second input of the AND gate 219 via a conductor 232. The output Q of the flip-flop 216 is coupled to a third input of the AND gate 219 via a conductor 274. A second terminal of the delay element 218 is coupled to a fourth input of the AND gate 219 via a conductor 276.

An automatic gain control reference voltage (AGC REF) is coupled to the negative input terminal of the comparator 234. The output of the AGC circuit 115 is coupled to the positive input of comparator 234 via the conductor 124. The output of comparator 234 is coupled to the second input of the AND gate 235 via the conductor 278. The output of the AND gate 235, which is the output of the SOS circuit 120, is coupled to an input of the microprocessor 119 via the conductor 128.

A high signal level on conductor 204 is inverted by inverter 241 to disable transistor 236 and thus to cause conductor 233 to be at a near ground potential, in other words to be at a low level. This low level applied to the second input of the AND gate 219 disables the gate irrespective of the levels of the signals applied to the other three inputs thereof. Thus when the signal on the conductor 204 is high, which represents the time period during which the value in the frequency counter 207 is being read out by one of the to decode circuits 209, 210 and during which it is controlled not to accept new information from the FM/AM mixer 110, the AND gate 219 is disabled.

When the signal on the conductor 203 is high, flip-flop 216 is enabled (clocked on) such that a signal from one of the decode circuits 209, 210 can activate the flip-flop 216 thereby to control the value at the output Q. The decode circuits 209, 210 generate a high level output signal at the output terminals thereof if the frequency measured by frequency counter 207 is within defined limits. Otherwise they generate a low level signal.

In the case of an AM signal, the received radio frequency (station) signal is deemed acceptable if the second IF signal is 450 kHz plus or minus 750 Hz. In a 1.28 millisecond sample period, a 750 Hz deviation from 450 kHz results in the frequency counter 207 reaching a count 1 above or below the centre frequency count of 576. Accordingly, the AM decode circuit 210 generates a high signal, if the count reached by the frequency counter 207 is between 575 and 577.

In the case of an FM signal, the received radio frequency (station) signal is deemed acceptable if the second IF signal is 450 kHz plus or minus 50 kHz. In a 1.28 millisecond sample period, a 50 kHz deviation results in the frequency counter 207 reaching a count of 64 above or below the centre frequency count of 576. Accordingly, the FM decode circuit 209 generates a high level signal if the count reached by the frequency counter 207 is between 512 and 640.

If the output of the selected decode circuit 209, 210 is high when the signal into the clock input of the flip-flop 216 from the conductor 203 is high (representing a "gate count" signal) the flip-flop 216 is set thereby outputting a high level signal to the conductor 274. The "gate count" signal is also supplied to the fourth input of the AND gate 219 after having been delayed by the delay element 218.

When receiving an FM radio frequency signal, the signal on conductor 233 is set to a high level if the level of noise in the signal is acceptable. This high level on conductor 233 is produced by the low level output of the FMTIC circuit 117 disabling the transistor 237 and thus causing the voltage at the drain terminal of that transistor to be above ground potential and at a high level when the transistor 236 is enabled.

On the other hand, if there is an unacceptable amount of noise in the signal, the output of the FMTIC circuit 117 is high thus enabling the transistor 237 and causing its drain terminal to be set to a low level, by being pulled close to ground potential. As a consequence, the conductor 233 is at a low level.

When the receiver 100 receives an AM radio signal, the output of the FMTIC circuit 117 is held low to disable transistor 237 and thereby to ensure that the signal on conductor 233 can become high when transistor 236 is enabled. This allows the AND gate 219 to respond to its other inputs, and in particular to the signal from the Q-output of the flip-flop 216.

On the other hand, when the signal on conductor 233 is at a low level, that is when the output of the FMTIC circuit 117 is high indicating that the noise level is unacceptable, the AND gate 219 is disabled such that the output thereof is always low, independent of signals applied to its other three inputs.

If the noise level is within acceptable limits, the low level signal generated by the FMTIC circuit 117 causes the transistor 237 to be biased off and the level of the signal on the conductor 233 to be determined by the signal level on conductor 204. Thus, when the signal on the conductor 204 is low, transistor 236 is biased on to cause the conductor 233 to be at a high level, and vice versa.

Transistors 236 and 237 are designed such that when both are enabled and conducting, the voltage at conductor 233 is close to ground, and thus low. This is accomplished by designing transistor 237 to have less resistance than transistor 236. Typically, this result is achieved by making transistor 236 physically larger than transistor 237.

During each 40 millisecond time period, one of the AM and FM decode circuits 209, 210 provides fifteen high or low output signals to the D-input of the flip-flop 216 through its respective transistor 211, 212. These signals appear at the Q-output of the flip-flop 216 and serve as the third input to the AND gate 219. Assuming that the noise level detected by the FMTIC circuit 117 is at or below the preset acceptable level and that the conductor 232 is at a high level, then the signals on the third input of AND gate 219 determine the output of the AND gate 219 and are essentially transported to the output of AND gate 219 to become the input signals to the persistence counter 229. Thus, during any given 40 millisecond time period the persistence counter 229 receives fifteen high or low input signals from the AND gate 219.

A count of eleven (11) or less low input signals to the persistence counter 229 in a 40 ms time period results in the output of the decode circuit 231 being low. This low level on conductor 272 results in conductor 232 being at a high level because of the inversion of the signal by inverter 240. This maintains the AND gate 219 enabled. On the other hand, the low level output disables the AND gate 235 and thereby causes the output thereof to be low. This output from the output to the SOS output terminal by means of the conductor 128 and is connected to an input to the microprocessor 119. This low level at the output of the SOS circuit 120 causes the microprocessor 119 to reject the candidate radio signal tested within the last 40 ms time period and to control the receiver 100 to receive another candidate radio signal. This other candidate radio signal is subsequently tested for acceptability.

A count of twelve (12) or more high level input signals to the persistence counter 229 in a 40 ms time period results in the output of the decode circuit 231 being set to a high level. The high level on conductor 272 results conductor 232 being at a low level, by means of the inverter 240, which disables the AND gate 219. This prevents the persistence counter 229 from being reset to zero before the microprocessor 119 resets it by outputting a 40 ms reset signal on the conductor 117 to the reset input of the persistence counter 229.

The high level signal on the conductor 272 causes the output of the AND gate 235 to become dependent only on the output of the comparator 234.

The comparator 234 generates a high level on conductor 278 if the output signal level of the AGC circuit 118 is greater than the AGC reference signal level. If the reverse is true, the output of comparator circuit 234 is low. A low level signal on conductor 278 disables the AND gate 235 and results in a low level signal being output from the SOS circuit 120.

Thus, if as a result of a test carried out on a candidate radio signal during a 40 ms time period, the output of the decode circuit 231 is high and the output of the comparator 234 is also high, the AND gate 235 outputs a high level signal onto conductor 128 indicating that the tested candidate radio signal is acceptable. This high level on the conductor 128 causes the microprocessor 119 to lock onto the candidate radio signal just tested and to allow this signal or channel to be listened to.

However, if the output of the decode circuit 231 or the output of the comparator 234 is low, then the signal output onto the conductor 128 is low. This causes microprocessor 119 to reject the candidate radio signal just tested and to control the receiver 100 so as to allow another candidate radio signal to be found and tested.

Accordingly, the radio receiver 100 accepts and allows the listening of a candidate radio signal if that signal passes frequency tests, field strength tests and, in the case of FM signals, a noise test.

## Claims

1. A radio receiver (100) comprising means to receive a signal; signal testing means (120), which signal testing means comprises strength measuring means (118) for measuring the amplitude of a received signal and adapted to generate a strength output signal related to the measured amplitude; characterised by the provision of frequency measuring means (207,209,210) for measuring the frequency of the received signal and adapted to generate a frequency output signal related to the measured frequency; and decision means (235) responsive to the strength output signal and the frequency output signal for generating a test output signal.

2. A radio receiver according to claim 1, wherein the strength measuring means comprises means (234) for comparing the measured amplitude with a reference value, the strength output signal being representative of the comparison; and wherein the frequency measuring means comprises means (209,210) for comparing the measured frequency with a reference value, the frequency output signal being representative of the comparison. `

3. A radio receiver according to claim 1 or 2, wherein the signal testing means comprises noise measuring means (117) for measuring the level of noise in the received signal and adapted to generate a noise output signal related to the measured level; the decision means being responsive to the noise output signal.

4. A radio receiver according to claim 3, wherein the noise measuring means comprises means (117) to compare the measured noise level with a reference value, the noise output signal being representative of the comparison.

5. A radio receiver according to claim 3 and 4, wherein the frequency measuring means comprises means (237) responsive to the noise output signal for enabling or inhibiting generation of the frequency output signal.

6. A radio receiver according to any preceding claim, wherein the frequency measuring means comprises clock means for generating at least one test period and a plurality of sampling periods within each test period; the frequency measuring means being adapted to measure the frequency of the received signal in each sampling period and to generate a frequency output signal for each measurement; the signal testing means (120) comprising persistence evaluation means (229) responsive to the frequency output signals and adapted to be incremented during a test period in dependence on each frequency output signal, and to generate a persistance output in dependence on the count reached in a said test period.

7. A radio receiver according to any preceding claim, wherein the frequency measuring means comprises a digital counter (207) for measuring the frequency of the received signal during each sampling period and adapted to generate a count output signal in respect of each measurement; and decoding means (209,210) coupled to the counting means for generating a said frequency output signal if the count output signal is within a predetermined range of counts.

8. A radio receiver according to claim 7, wherein the radio receiver is an AM/FM receiver, the decoding means comprising independent AM decoding means (209) and FM decoding means (210), each coupled to the digital counter (207) and adapted to generate frequency output signals; means (211,212,214) being provided to select one or the other of the AM and FM decoding means (209,210).

9. A radio receiver according to claims 8 and 5, wherein the noise measuring means is actuated when the FM decoding means is selected, the enabling or inhibiting means (237) being set to enable the generation of frequency output signals when the AM decoding means is selected.

10. Apparatus for testing the suitability of a radio signal for listening purposes, which radio signal has been transferred onto an Intermediate Frequency, the apparatus comprising means (207) to measure the frequency of the transferred signal, means (209,210) to measure the deviation in frequency of the signal from the Intermediate Frequency, and means (209,210) to compare the deviation with a predetermined value, the result of the comparison being indicative of the suitability of the signal.

FIG. 1

EP 0 415 610 A2

FIG. 2

FIG. 3

TIME (MILLISECONDS)

EP 0 415 610 A2